(19) **Europäisches Patentamt**

**European Patent Office**

**Office européen des brevets**

(11) **EP 1 677 445 B1**

(12) **EUROPEAN PATENT SPECIFICATION**

(45) Date of publication and mention
of the grant of the patent:
**06.09.2006 Bulletin 2006/36**

(51) Int Cl.:
*H04B 17/00* (2006.01)       *G01R 29/26* (2006.01)
*H04B 1/10* (2006.01)       *H04L 1/20* (2006.01)

(21) Application number: **04293155.0**

(22) Date of filing: **28.12.2004**

(54) **Improved blind SNR estimation**

Verbesserte blinde SNR-schätzung

Estimation aveugle de SRB améliorée

(84) Designated Contracting States:
**AT BE BG CH CY CZ DE DK EE ES FI FR GB GR
HU IE IS IT LI LT LU MC NL PL PT RO SE SI SK TR**

(43) Date of publication of application:
**05.07.2006 Bulletin 2006/27**

(73) Proprietor: **ALCATEL**
**75008 Paris (FR)**

(72) Inventor: **Buné, Paul A.M.**
**70806 Kornwestheim (DE)**

(74) Representative: **Rausch, Gabriele et al**
**Alcatel**
**Intellectual Property Group, Stuttgart**
**70430 Stuttgart (DE)**

(56) References cited:
- HUA XU ET AL: "A non-data-aided SNR estimation algorithm for QAM signals" COMMUNICATIONS, CIRCUITS AND SYSTEMS, 2004. ICCCAS 2004. 2004 INTERNATIONAL CONFERENCE ON CHENGDU, CHINA 27-29 JUNE 2004, PISCATAWAY, NJ, USA,IEEE, US, 27 June 2004 (2004-06-27), pages 103-107Vol1, XP010731908 ISBN: 0-7803-8647-7
- WIESEL A ET AL: "Non-data-aided signal-to-noise-ratio estimation" ICC 2002. 2002 IEEE INTERNATIONAL CONFERENCE ON COMMUNICATIONS. CONFERENCE PROCEEDINGS. NEW YORK, NY, APRIL 28 - MAY 2, 2002, IEEE INTERNATIONAL CONFERENCE ON COMMUNICATIONS, NEW YORK, NY : IEEE, US, vol. VOL. 1 OF 5, 28 April 2002 (2002-04-28), pages 197-201, XP010589485 ISBN: 0-7803-7400-2
- PAULUZZI D R ET AL: "A comparison of SNR estimation techniques for the AWGN channel" IEEE TRANSACTIONS ON COMMUNICATIONS, IEEE INC. NEW YORK, US, vol. 48, no. 10, October 2000 (2000-10), pages 1681-1691, XP002289928 ISSN: 0090-6778

**Description**

The invention relates to a method for estimating the signal to noise ratio (=SNR) ($\gamma$) of a modulated communication signal ($r_n$) including a data symbol component ($s_n$) and a noise component ($n_n$).

An overview of SNR estimation techniques is given in D. R. Pauluzzi, N.C. Beaulieu, IEEE Trans. Comm. Vol. 48, Nr. 10, P. 1681-1691 (October 2000).

In order to provide optimal functioning of advanced mobile radio modules, accurate signal to noise ratio (=SNR) estimation of modulated communication signals is necessary. On the physical layer, SNR values are used in maximum-ratio combining and turbo-decoding. On higher layers, SNR values are used for call setup, macrodiversity and handover control.

In environments with varying SNR, such as mobile radio networks, the determination of an SNR value must be rather quick.

The SNR value $\gamma$ is defined as the ratio of signal power and noise power, i.e.

$$\gamma = \frac{signal\quad power}{noise\quad power} = \frac{\left| signal\quad amplitude \right|^2}{noise\quad power}.$$

SNR estimation can be done data-assisted (=DA) or Non-data assisted (NDA). The latter is often called a "blind" estimation.

In the case of data assisted SNR estimation, a set of samples (with one sample typically corresponding to one bit) is known in advance. After a transmission of the set of samples, the received data is compared with the original data by means of a data-assisted maximum likelihood estimation. The known set of samples can be a preamble or a training sequence.

If the transmitted set of samples is not known in advance, a blind estimation algorithm must be applied. Known algorithms of blind SNR estimation include a) standard received data aided (=RDA) maximum likelihood SNR estimation (see e.g. D. Pauluzzi, N. Beaulieu, IEEE Trans. Comm., Vol 48, No 10, pp. 1681-1691, October 2000),

   b) iterative SNR estimation (see e.g. B. Li et al., IEEE Commun. Lett. Vol 6, No 11, pp. 469-471, November 2002), and
   c) Kurtosis SNR estimation (see e.g. R. Matzner, K. Letsch, Proc. IEEE-IMS Workshop on Information Theory and Statistics, Alexandria/VA, USA, p. 68ff, October 1994).

The paper "Hua Xu; Zupeng Li; Hui Zheng; from 2004 International Conference on Communications, Circuits and Systems, 2004. ICCCAS 2004. Volume 1, 27-29 June 2004 Page(s):103 - 107 Vol.1" also show an algorithm which corrects, by mean of a non linear function, a parameter calculated from received data to obtain a SNR estimation of a QAM signal.

However, these known algorithms are rather inaccurate for low numbers of samples. Moreover, in particular the iterative SNR estimation is cumbersome and time consuming.

It is the object of the present invention to provide a robust SNR estimation method for a modulated communication signal, wherein the method has a high accuracy even for low numbers of processed samples.

This object is achieved by a method as introduced in the beginning, characterized in that an intermediate SNR value ($\gamma_{RDA}$) of the modulated communication signal is derived from a data assisted maximum-likelihood estimation, the assisting data not being known in advance but being reconstructed from samples of the modulated communication signal ($r_n$), and that an estimated SNR value ($\gamma_{RDA-ER}$) is determined by a controlled non-linear conversion of the intermediate SNR value ($\gamma_{RDA}$).

The inventive method estimates the SNR of the modulated communication signal by means of a conversion of the intermediate SNR value. The intermediate SNR value is obtained by a standard RDA maximum likelihood SNR estimation of the modulated communication signal. The intermediate SNR value $\gamma_{RDA}$ deviates from the true SNR value $\gamma$. In particular, for small values of the true SNR value $\gamma$, i.e. $\gamma \rightarrow 0$, $\gamma_{RDA}$ is much larger than $\gamma$. This deviation is compensated for by the controlled non-linear conversion of the intermediate SNR value.

The controlled non-linear conversion can be done by means of a conversion table based on an experimentally predetermined correlation between $\gamma_{RDA}$ and $\gamma$. It is preferred, however, to model the correlation between $\gamma_{RDA}$ and $\gamma$ mathematically and to use the modelled correlation for conversion. For modelling, information about and/or suitable assumptions for the characteristics of the modulated communication signal are useful. In particular, the type of modulation should be known. It has been found that signals modulated by binary phase shift keying (=BPSK) can be handled very well by the inventive method. Moreover, the type of noise in the modulated communication signal can often be assumed to have a Gaussian distribution.

With the aid of the highly accurate and robust estimated SNR values obtained over a broad SNR range, as determined by means of the invention, it is possible to improve receiver performance, which in turn allows for distressing of margins e.g. in network planning, in particular lower UL/DL transmission power requirements and larger distances between base stations, nodes B and the like.

A highly preferred variant of the inventive method is characterized in that the controlled non-linear conversion is performed by a correction function $\Psi^{-1}$, with $\gamma_{RDA\text{-}ER} = \Psi^{-1}(\gamma_{RDA})$, wherein the correction function $\Psi^{-1}$ is the inverse function of an estimated deviation function $\Psi$, with the estimated deviation function $\Psi$ approximating a true deviation function $\Psi_{true}$ correlating the deviation of $\gamma_{RDA}$ from $\gamma$, i.e. $\gamma_{RDA} = \Psi_{true}(\gamma)$ and $\Psi(\gamma) \approx \Psi_{true}(\gamma)$. Typically, the estimated deviation function is determined by a mathematic model. Its inverse function, i.e. the correction function, can be obtained by mirroring the estimated deviation function at the bisecting line of the first quadrant in the coordinate system. If the estimated deviation function is simple enough, its inverse function can also be calculated analytically. The estimated deviation function $\Psi(\gamma)$ can be calculated by setting it equal to the intermediate SNR signal, which in turn is the ratio of the estimated signal power and the estimated noise power of the modulated communication signal. The estimated signal power and estimated noise power, then, must be expressed as a function of $\gamma$, with the latter requiring suitable assumptions, such as e.g. an infinite number of samples to be processed.

In a preferred further development of this method, $\Psi$ is chosen such that $\Psi(\gamma) = \Psi_{true}(\gamma)$ for large numbers of $N$, i.e. $N \to \infty$, with $N$ being the number of samples of the modulated communication signal ($r_n$) being processed. The estimated deviation function found in this way is then applied to data with a finite number of samples, too. In many cases, in particular with a BPSK modulation and Gaussian noise distribution, $\Psi_{true}(\gamma)$ can be determined accurately for $N \to \infty$. The latter assumption is justified in most real situations, when sufficiently large numbers of samples are available. In particular, a number of 100 samples or more is sufficient.

In a further preferred development of said variant of the inventive method,

$$\Psi(\gamma) = \cfrac{1}{\cfrac{\gamma+1}{\left(\sqrt{\gamma}\,\mathrm{erf}\left(\sqrt{\dfrac{\gamma}{2}}\right)+\sqrt{\dfrac{2}{\pi}}e^{-\frac{\gamma}{2}}\right)^2} - 1}.$$ This choice of $\Psi(\gamma)$ gives highly accurate results in case of a BPSK modulation of the modulated communication signal.

In an advantageous development of the variant, $\Psi^{-1}$ is applied by means of an approximation table. An approximation table provides very quick access to values of the correction function, which are listed in the table. Alternatively, online numerical or analytical calculation of values of the correction function is also possible, but more time consuming.

Further preferred is a development of said variant wherein $\Psi(\gamma) = \Psi_{HA}(\gamma) = \sqrt{\gamma^2 + \left(\dfrac{2}{\pi - 2}\right)^2}$. This hyperbolic function is a good approximation of $\Psi_{true}(\gamma)$ in case of BPSK modulation. Its inverse can be calculated straightforwardly as $\Psi_{HA}^{-1}(\gamma) = \sqrt{\gamma^2 - \left(\dfrac{2}{\pi - 2}\right)^2}$ for $\gamma \geq \dfrac{2}{\pi - 2}$, and $\Psi_{HA}^{-1}(\gamma) = 0$ for $\gamma \leq \dfrac{2}{\pi - 2}$. Thus, the correction function is available analytically, which simplifies and accelerates the determination of the estimated SNR value $\gamma_{RDA\text{-}ER}$.

In another variant of the inventive method, the number $N$ of samples of the modulated communication signal ($r_n$) being processed is equal or less than 500, preferably equal or less than 100. In these cases, the inventive method already provides estimated SNR values of high accuracy, whereas known methods show worse accuracy. For higher values of $N$, such as an $N$ of 1000 or larger, it is worth mentioning that the inventive method provides equally accurate estimated SNR values as known methods, but typically with less effort.

Also in the scope of the invention is a computer program for estimating the signal to noise ratio ($\gamma$) of a modulated communication signal ($r_n$) according to the inventive method. The computer program may be saved on a storage medium, in particular a hard disk or a portable storage medium such as a compact disc.

The invention also comprises a receiver system for estimating the signal to noise ratio ($\gamma$) of a modulated communication signal ($r_n$) according to the inventive method. The receiver system comprises a receiver unit. The receiver unit can receive transmitted signals, with the transmission carried out by radio or an optical fiber line, e.g.. The inventive method can be performed directly with the received transmitted signals, i.e. at the receiver unit. Alternatively, the inventive method can be applied after a channel decoding, such as turbo decoding, of the received transmitted signals. In the latter case, the method is performed with "soft" signals.

Finally, the invention is also realized in an apparatus, in particular a base station or a mobile station, comprising an inventive computer program and/or an inventive receiver system as described above. A typical mobile station is a mobile phone. An inventive apparatus can be part of a 3G or B3G network, in particular a UMTS network or a WLAN network.

Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention.

Drawings

The invention is shown in the drawing.

Fig. 1    shows a binary transmission system with a noisy channel for use with the inventive method;

Fig. 2    shows plots of an estimated deviation function $\Psi(\gamma)$ for a BPSK real channel and a hyperbolic function $\Psi_{HA}$ (y) which approximates the former function, as well as their inverse functions in accordance with the invention;

Fig. 3a   shows a diagram plotting normalized mean square errors of estimated SNR values with respect to the true SNR values as a function of the true SNR value, for standard RDA maximum likelihood SNR estimation (state of the art), inventive RDA-ER and inventive RDA-ERHA, with 100 samples processed per SNR estimation;

Fig. 3b   shows a diagram corresponding to Fig. 3a, with 1000 samples per SNR estimation;

Fig. 4a   shows a diagram plotting normalized mean square errors of estimated SNR values with respect to the true SNR values as a function of the true SNR value, for standard RDA maximum-likelihood SNR estimation (state of the art), inventive RDA-ER, Iterative method (state of the art) and Kurtosis method (state of the art) with 100 samples processed per SNR estimation;

Fig. 4b   show a diagram corresponding to Fig. 4a, with 1000 samples processed per SNR estimation.

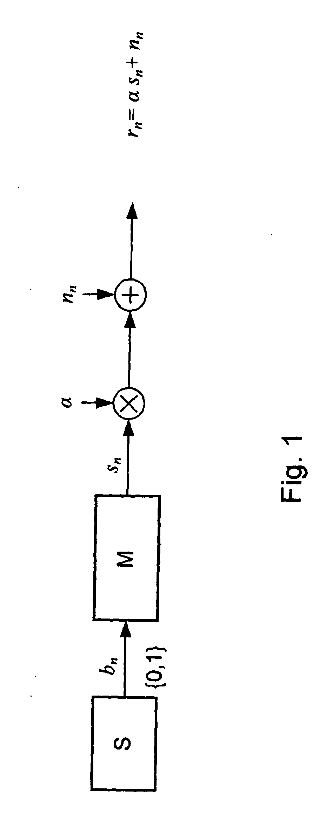

The invention deals with the estimation of SNR values in a transmission system, such as a radio telephone network. A transmission system for use with the invention is shown schematically in **Fig. 1.** At a source S, binary data is generated. The binary data may contain information of a telephone call, for example. The binary data consists of a number of bits $b_n$, with $n$ : the index number of the bits, running from 0 to $N$ -1, with $N$ : the total number of bits of the binary data. Each bit may have a value of 0 or 1. In order to transport the binary data, it is modulated in a modulator M. A typical modulation is the binary phase shift keying (BPSK) modulation, resulting in values of a data symbol component $s_n$ of +1 or -1. At the physical transmission of the data symbol component $s_n$, typically applying a carrier frequency, $s_n$ is amplified by a factor $\alpha$. Also, noise $n_n$ is superposed by the channel to the amplified data symbol component $\alpha \cdot s_n$. The amplification factor $\alpha$ and the noise level are unknown initially. Thus in total, a modulated communication signal $r_n$ = $\alpha \cdot s_n + n_n$ is generated and ready for detection at a receiver system. The receiver system may be part of a mobile phone, for example. During the physical transport, other data symbol components may be transmitted at the same time at other frequency ranges and/or at other (spreading) code ranges. These other data symbol components can be neglected in this context; they may affect the noise component $n_n$, though.

In the following, a BPSK modulation is assumed as well as a real channel, with a noise probability density function (=PDF) of Gaussian type

$$p(n_n) = \frac{1}{\sigma\sqrt{2\pi}} e^{-\frac{n_n^2}{2\sigma^2}},$$

with σ: standard deviation or noise amplitude. However, other signal characteristics are possible in accordance with the inverntion.

When making a data-aided (DA) maximum-likelihood SNR estimation, an estimated amplitude $\alpha$ with known

"pilots" $s_n$, i.e. a set of $N$ known data symbol component values, is calculated as

$$\hat{\alpha} = \mathrm{E}\left\{\frac{r_n}{s_n}\right\} = \frac{1}{N}\sum_{n=0}^{N-1}\frac{r_n}{s_n} = \frac{1}{N}\sum_{n=0}^{N-1}r_n s_n \,,$$

with $s_n = \{+1, -1\}$. Note that a hat $\wedge$ above a value indicates an estimated value, and E is the estimation operation determining the mean value of its input values. The estimated noise power $\sigma^2$ (second moment) is calculated as

$$\hat{\sigma}^2 = \mathrm{E}\left\{(r_n - \hat{\alpha}s_n)^2\right\} = \mathrm{E}\{r_n^2\} - \hat{\alpha}^2\,\mathrm{E}\{s_n^2\} = \frac{1}{N-v}\sum_{n=0}^{N-1}(r_n - \hat{\alpha}s_n)^2 \,,$$

with $v$ being a constant to be chosen according to literature (D.R. Pauluzzi, N.C. Beaulieu, l.c.) as follows: Maximum likelihood for $\sigma^2$ estimation: $v = 0$; Bias elimination for $\sigma^2$ estimation: $v = 1$; Minimum MSE for $\sigma^2$ estimation: $v = -1$; Bias elimination for y estimation: $v = 3$; Minimum MSE for y estimation: $v = 5$. The data-aided SNR estimation then results in

$$\hat{\gamma}_{DA} = \frac{\hat{\alpha}^2}{\hat{\sigma}^2} = \frac{\left(\dfrac{1}{N}\sum_{n=0}^{N-1}r_n s_n\right)^2}{\dfrac{1}{N-v}\sum_{n=0}^{N-1}r_n^2 - \dfrac{1}{N(N-v)}\left(\sum_{n=0}^{N-1}r_n s_n\right)^2} = \frac{(N-v)}{N}\hat{\gamma}_{v=0}\,.$$

In case of a **"blind"**, i.e. received-data-aided (RDA) maximum likelihood SNR estimation, the "pilots" are estimated based on receiver decisions, identical to the first absolute moment. The estimated amplification factor $\alpha$ is calculated as

$$\hat{\alpha} = \mathrm{E}\{r_n \hat{s}_n\} = \mathrm{E}\{r_n\,\mathrm{signum}(r_n)\} = \mathrm{E}\{|r_n|\} = \frac{1}{N}\sum_{n=0}^{N-1}|r_n|\,.$$

Noise power is estimated correspondingly (compare DA above). Accordingly, an SNR value is estimated, with

$$\hat{\gamma}_{BPSK1,RDA} = \frac{\left(\dfrac{1}{N}\sum_{k=0}^{N-1}|r_n|\right)^2}{\dfrac{1}{N-v}\sum_{n=0}^{N-1}r_n^2 - \dfrac{1}{N(N-v)}\left(\sum_{n=0}^{N-1}|r_n|\right)^2}\,.$$

This value $\gamma_{BPSK1,RDA}$ is the result of the standard RDA maximum likelihood SNR estimation, as known from literature.

However, by using estimated data symbol component values $s_n$ instead of the true data symbol component values $s_n$, error is introduced. For sufficiently large SNR values $\gamma$, $\gamma_{BPSK1,RDA}$ approximates $\gamma$ very well, but for small values of $\gamma$, the estimated values $\gamma_{BPSK1,RDA}$ are too large.

According to the invention, the $\gamma_{BPSK1,RDA}$ value is set equal to an estimated deviation function $\Psi(\gamma)$. For this purpose, the terms of $\gamma_{BPSK1,RDA}$ are expressed as functions of the true SNR value $\gamma$, requiring some approximations and assumptions:

$$\hat{\alpha} = E\{|r_n|\} = E\{\alpha + |n_n|\} = \frac{1}{\sigma}\sqrt{\frac{2}{\pi}} \int_0^\infty \rho\, e^{-\frac{\rho^2+\alpha^2}{2\sigma^2}} \cosh\left(\frac{\alpha}{\sigma^2}\rho\right) d\rho = \alpha\, \mathrm{erf}\left(\sqrt{\frac{\gamma}{2}}\right) + \sigma\sqrt{\frac{2}{\pi}}e^{-\frac{\gamma}{2}}$$

$$\hat{\alpha}^2 + \hat{\sigma}^2 = E\{r_n^2\} = \frac{1}{\sigma\sqrt{2\pi}} \int_0^\infty \sqrt{\upsilon}\, e^{-\frac{\upsilon+\alpha^2}{2\sigma^2}} \cosh\left(\frac{\alpha}{\sigma^2}\sqrt{\upsilon}\right) d\upsilon = \alpha^2 + \sigma^2$$

$$\hat{\gamma}_{\text{BPSK1,RDA}} = \frac{\hat{\alpha}^2}{\hat{\sigma}^2} = \frac{(E\{|r_n|\})^2}{E\{r_n^2\}-(E\{|r_n|\})^2} = \frac{1}{\frac{E\{r_n^2\}}{(E\{|r_n|\})^2}-1} = \frac{1}{\frac{\gamma+1}{\left(\sqrt{\gamma}\,\mathrm{erf}\left(\sqrt{\frac{\gamma}{2}}\right)+\sqrt{\frac{2}{\pi}}e^{-\frac{\gamma}{2}}\right)^2}-1} \stackrel{\Delta}{=} \Psi(\gamma)$$

In particular, the one-dimensional Gaussian type noise PDF as defined in the beginning has been introduced in this calculation, and it is based on the BPSK modulation (indicated by the index BPSK1, where the "1" represents the one-dimensionality of the real channel and its noise).

The result $\gamma_{\text{BPSK1,RDA}}$ of the standard RDA maximum likelihood estimation is used as a starting point for the actual calculation of an estimated SNR value $\gamma_{BPSK1,RDA\text{-}ER}$ in accordance with the invention. For this reason, the $\gamma_{\text{BPSK1,RDA}}$ is called an intermediate SNR value. The "ER" index of $\gamma_{BPSK1,RDA\text{-}ER}$ indicates an extended range, i.e. an improved range of application with the invention. For calculating $\gamma_{BPSK1,RDA\text{-}ER}$, the inverse function $\Psi^{-1}$ of the estimated deviation function $\Psi(\gamma)$ is determined, and the intermediate SNR value $\gamma_{\text{BPSK1,RDA}}$ is assigned to $\Psi^{-1}$, with

$$\hat{\gamma}_{\text{BPSK1,RDA-ER}} = \Psi^{-1}\left(\hat{\gamma}_{\text{BPSK1,RDA}}\right).$$

Note that $\Psi^{-1}(x) = 0$ for $x \le \frac{2}{\pi-2}$. The correlation of $\gamma_{\text{BPSK1,RDA}} = \Psi(\gamma)$ is, due to the assumptions and simplifications necessary to express $\gamma_{\text{BPSK1,RDA}}$ in terms of $\gamma$, only an approximation of the true and exact correlation $\gamma_{BPSK1,RDA} = \Psi_{true}(\gamma)$. The better $\Psi(\gamma)$ approximates $\Psi_{true}(\gamma)$, the more accurate is the estimated SNR value $\gamma_{BPSK1,RDA\text{-}ER}$ in accordance with the invention.

In the above-calculated case of BPSK over a real channel, the estimated deviation function $\Psi$ cannot be inverted to a closed form inverse function, so numerical calculation is necessary. However, for simplification, the estimated deviation function $\Psi$ can be approximated by a hyperbolic function $\Psi_{HA}$ which is easy to invert:

$$\Psi(x) \approx \Psi_{HA}(x) = \sqrt{x^2 + \left(\frac{2}{\pi-2}\right)^2}$$

$$\Psi^{-1}(x) \approx \Psi_{HA}^{-1}(x) = \sqrt{x^2 - \left(\frac{2}{\pi-2}\right)^2} \quad \text{for } x \ge \frac{2}{\pi-2}$$

$$\Psi^{-1}(x) = \Psi_{HA}^{-1}(x) = 0 \quad \text{for } x \le \frac{2}{\pi-2}.$$

Then the inventive estimated SNR value can be calculated as

$$\hat{\gamma}_{\text{BPSK1,RDA-ERHA}} = \Psi_{HA}^{-1}\left(\hat{\gamma}_{\text{BPSK1,RDA}}\right).$$

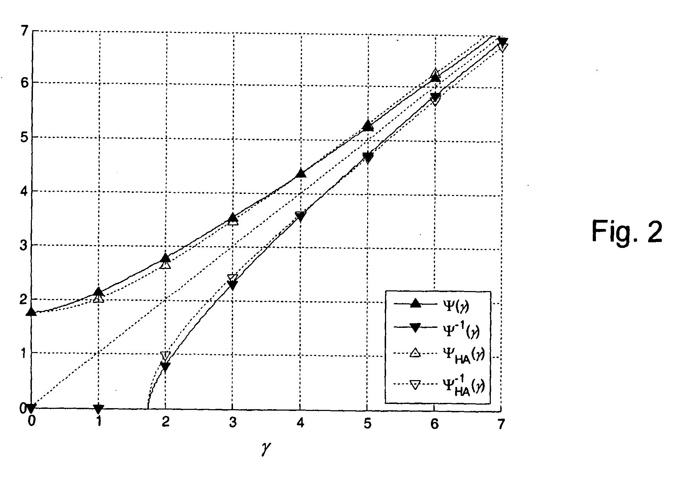

In Fig. 2, the function $\Psi(\gamma) = \dfrac{1}{\dfrac{\gamma+1}{\left(\sqrt{\gamma}\,\mathrm{erf}\left(\sqrt{\dfrac{\gamma}{2}}\right)+\sqrt{\dfrac{2}{\pi}}e^{-\frac{\gamma}{2}}\right)^2}-1}$ as well as the function

$\Psi_{HA}(\gamma) = \sqrt{\gamma^2 + \left(\dfrac{2}{\pi-2}\right)^2}$ which approximates the former function are plotted for comparison. The differences are about 0.2 absolutely and about 10% relatively at maximum. Their inverse functions, which are available by mirroring the plots at the bisecting line of the first quadrant (dashed line without symbols), are also indicated in Fig. 2.

In order to quantify the accuracy of the inventive method for estimating SNR values of modulated communication signals, different SNR estimation methods of the state of the art and according to the invention have been tested.

A number $N_t$ of tests is performed with every method. Each test is done with a disjunctive set of $N$ symbols (or bits, samples). The corresponding modulated communication signals $r_n$ of each set, with $n$ running from 0 to $N$-1, have a known true SNR value $\gamma$. In each test, an estimated SNR value $\gamma_m$ of the tested set is determined by means of the currently tested method, with $m$ : test index (or index of tested sets) running from 0 to $N_t$-1. The distribution of the estimated SNR values $\gamma_m$ as compared with the true SNR value $\gamma$ is analysed by calculating a normalized mean square error (NMSE) of $\gamma_m$:

$$\mathrm{NMSE}\{\hat{\gamma}_m\} = \frac{\mathrm{MSE}\{\hat{\gamma}_m\}}{\gamma^2} = \frac{\mathrm{E}\left\{(\hat{\gamma}_m - \gamma)^2\right\}}{\gamma^2} = \frac{1}{N_t\gamma^2}\sum_{m=0}^{N_t-1}(\hat{\gamma}_m - \gamma)^2 .$$

The NMSE values are, for each method, a function of the true SNR value $\gamma$ and a function of the number of samples $N$ of each set.

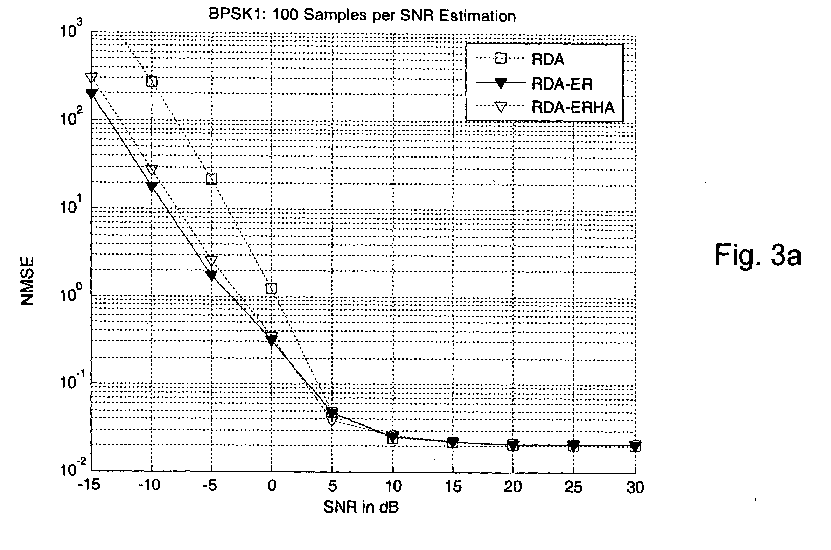

Test results are plotted in **Fig. 3a.** The abscissa shows the true SNR $\gamma$ in dB, and the ordinate shows on a logarithmic scale the NMSE values of estimated SNR values for three different methods, i.e. standard RDA maximum likelihood estimation of the state of the art, inventive RDA-ER maximum likelihood estimation with the estimated deviation function $\Psi$ as in Fig. 2, and inventive RDA-ERHA maximum likelihood estimation with the estimated deviation function $\Psi_{HA}$ as in Fig. 2. For the diagram, all in all $10^6$ SNR estimations (tests) have been calculated, with $N$ =100 samples per SNR estimation.

For low SNR values (0 dB and less), the NMSE values of the inventive RDA-ER and RDA-ERHA methods are much lower than the NMSE values of the state of the art standard RDA method. In other words, the inventive methods are more accurate in this range. In particular, at -10 dB and -5 dB, the inventive methods are about 10 times more accurate than standard RDA. In said range, RDA-ER NMSE values are about half of the RDA-ERHA NMSE values. For higher SNR values (5 dB and above), all three methods are roughly equally accurate.

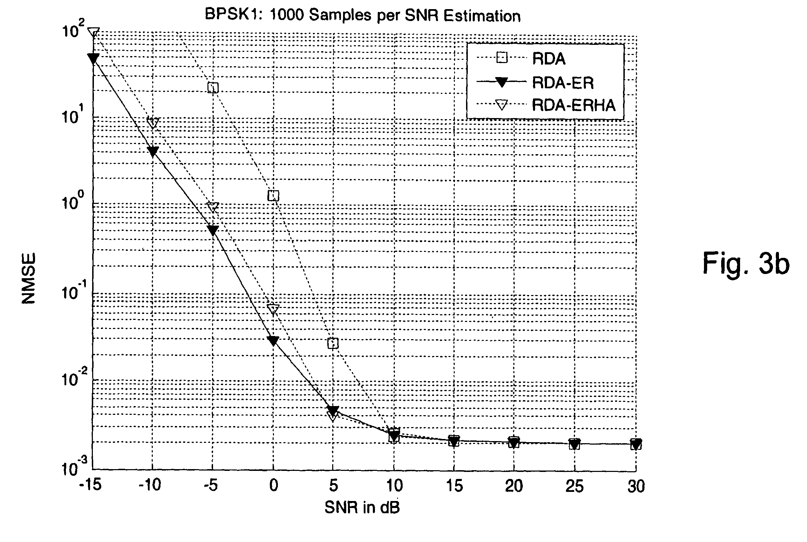

For **Fig. 3b,** the same tests as for Fig. 3a have been performed, but with $N$ =1000 samples per SNR estimation. The relative difference in accuracy between state of the art RDA on the one hand and inventive RDA-ER and RDA-ERHA is even higher, showing the improvement by the inventive method.

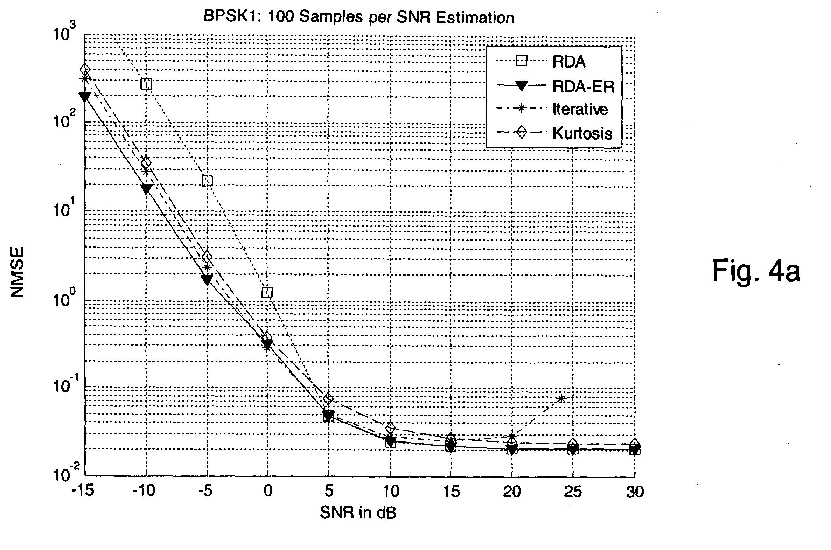

For **Fig. 4a,** the same tests as for Fig. 3a have been performed, with $N$ =100 samples per SNR estimation again. The NMSE values of estimated SNR values are plotted for the standard RDA maximum likelihood estimation method of the state of the art, the inventive RDA-ER maximum likelihood estimation method, the Iterative method of the state of the art, and the Kurtosis method of the state of the art. The inventive RDA-ER method has the lowest NMSE values, indicating the highest accuracy, over a very broad SNR range. In the range of 0 dB to 5 dB, the Iterative method is roughly equal to the inventive RDA-ER method.

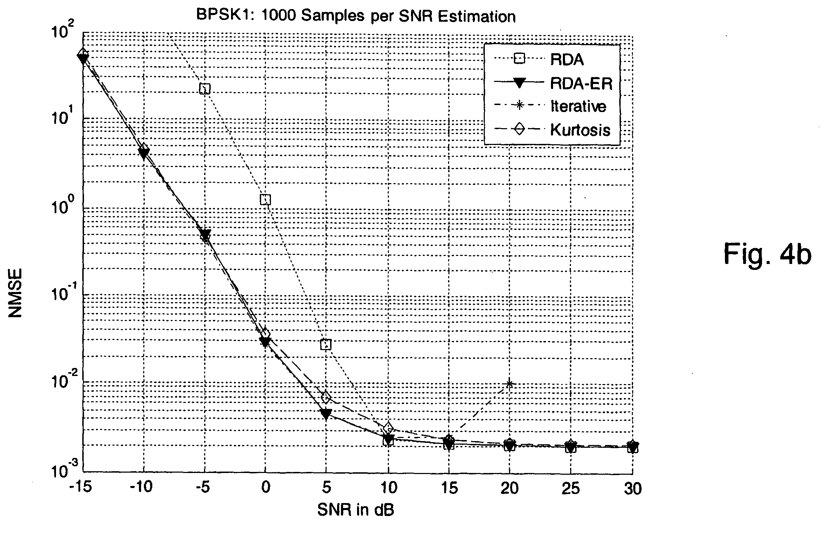

For **Fig. 4b,** the same tests as for Fig. 4a have been performed, but with $N$ =1000 samples per SNR estimation. For low SNR values (0 dB and less), the inventive RDA-ER method, the Iterative method and the Kurtosis method are equally accurate. For SNR values of 10 dB and above, the inventive RDA-ER method clearly outperforms the Iterative method. Moreover, the inventive RDA-ER method outperforms the Kurtosis method between 0 dB and 15 dB.

In summary, the inventive SNR estimation method has been tested for a BPSK channel over a real AWGN channel. It outperforms or is at least equal to known blind SNR estimation algorithms. The inventive method can easily be used with other signal modulations over real or complex channels. The inventive method requires only limited effort (a little more than the well-known maximum likelihood data assisted estimation); in particular, it does neither need iteration nor decoding/re-encoding of protected data. Finally, to avoid the storage and the handling of the optimal interpolation curve $\Psi^{-1}$, a hyperbolical approximation is available which allows instantaneous computation with only minor performance degradation.

**Claims**

1. Method for estimating the signal to noise ratio $\gamma$ of a modulated communication signal $r_n$ including a data symbol component $s_n$ and a noise component $n_n$, wherein an intermediate SNR value $\gamma_{RDA}$ of the modulated communication signal is determined, and wherein an estimated SNR value $\gamma_{RDA-ER}$ is determined by a controlled non-linear conversion of the intermediate SNR value $\gamma_{RDA}$,
   **characterized in that**
   the intermediate SNR value $\gamma_{RDA}$ is derived from a data assisted maximum-likelihood estimation, the assisting data not being known in advance but being reconstructed from samples of the modulated communication signal $r_n$.

2. Method according to claim 1, **characterized in that** the controlled non-linear conversion is performed by a correction function $\Psi^{-1}$, with $\gamma_{RDA-ER} = \Psi^{-1}(\gamma_{RDA})$, wherein the correction function $\Psi^{-1}$ is the inverse function of an estimated deviation function $\Psi$, with the estimated deviation function $\Psi$ approximating a true deviation function $\Psi_{true}$ correlating the deviation of $\gamma_{RDA}$ from $\gamma$, i.e. $\gamma_{RDA} = \Psi_{true}(\gamma)$ and $\Psi(\gamma) \approx \Psi_{true}(\gamma)$.

3. Method according to claim 2, **characterized in that** $\Psi$ is chosen such that $\Psi(\gamma) = \Psi_{true}(\gamma)$ for large numbers of N, i.e. $N \to \infty$, with $N$ being the number of samples of the modulated communication signal $r_n$ being processed.

4. Method according to claim 2, **characterized in that**

$$\Psi(\gamma) = \frac{1}{\dfrac{\gamma+1}{\left(\sqrt{\gamma}\,\mathrm{erf}\left(\sqrt{\dfrac{\gamma}{2}}\right)+\sqrt{\dfrac{2}{\pi}}e^{-\frac{\gamma}{2}}\right)^2} - 1} \; .$$

5. Method according to claim 2, **characterized in that** $\Psi^{-1}$ is applied by means of an approximation table.

6. Method according to claim 2, **characterized in that**

$$\Psi(\gamma) = \Psi_{HA}(\gamma) = \sqrt{\gamma^2 + \left(\frac{2}{\pi-2}\right)^2} \; .$$

7. Method according to claim 1, **characterized in that** the number $N$ of samples of the modulated communication signal $r_n$ being processed is equal or less than 500, preferably equal or less than 100.

8. Computer program for estimating the signal to noise ratio $\gamma$ of a modulated communication signal $r_n$, said program implementing the steps of the methods defined in claim 1

9. Receiver system including means for performing the steps of the method defined in claim 1.

10. Apparatus, in particular a base station or a mobile station, comprising a computer program according to claim 8 and/or a receiver system according to claim 9.

**Patentansprüche**

1. Verfahren zum Schätzen des Signal-Rausch-Abstandes $\gamma$ eines modulierten Kommunikationssignals $r_n$, das eine Datensymbolkomponente $s_n$ und eine Rauschkomponente $n_n$ enthält, in welchem ein SNR-Zwischenwert $\gamma_{RDA}$ des modulierten Kommunikationssignals bestimmt wird und in welchem der geschätzte SNR-Wert $\gamma_{RDA-ER}$ durch eine gesteuerte nichtlineare Umwandlung des SNR-Zwischenwertes $\gamma_{RDA}$ bestimmt wird,
   **dadurch gekennzeichnet, daß**
   der SNR-Zwischenwert $\gamma_{RDA}$ von einer datenunterstützten Maximum-Likelihood-Schätzung abgeleitet wird, die unterstützenden Daten im Voraus nicht bekannt sind, aber aus Abtastwerten des modulierten Kommunikationssignals $r_n$ rekonstruiert werden.

2. Verfahren nach Anspruch 1, **dadurch gekennzeichnet, daß** die gesteuerte nichtlineare Umwandlung durch eine Korrekturfunktion $\Psi^{-1}$ durchgeführt wird, mit $\gamma_{RDA-ER} = \Psi^{-1}(\gamma_{RDA})$, in welchem die Korrekturfunktion $\Psi^{-1}$ die Umkehrfunktion einer geschätzten Abweichungsfunktion $\Psi$ ist, mit der geschätzten Abweichungsfunktion $\Psi$, die eine wahre Abweichungsfunktion $\Psi_{true}$ approximiert, die die Abweichung von $\gamma_{RDA}$ von $\gamma$ in Wechselbeziehung bringt, d.h. $\gamma_{RDA} = \Psi_{true}(\gamma)$ und $\Psi(\gamma) \approx \Psi_{true}(\gamma)$.

3. Verfahren nach Anspruch 2, **dadurch gekennzeichnet, daß** $\Psi$ so ausgewählt wird, daß $\Psi(\gamma) = \Psi_{true}(\gamma)$ für große Anzahlen von N ist, d.h. $N \to \infty$, mit $N$ - der Anzahl der Abtastwerte des zu verarbeitenden modulierten Kommunikationssignals $r_n$.

4. Verfahren nach Anspruch 2, **dadurch gekennzeichnet, daß**

$$\Psi(\gamma) = \frac{1}{\left(\sqrt{\gamma}\ \mathrm{erf}\left(\sqrt{\frac{\gamma}{2}}\right) + \sqrt{\frac{2}{\pi}}\ e^{-\frac{\gamma}{2}}\right)^2} - 1 \quad .$$

5. Verfahren nach Anspruch 2, **dadurch gekennzeichnet, daß** $\Psi^{-1}$ mittels einer Approximationstabelle angewendet wird.

6. Verfahren nach Anspruch 2, **dadurch gekennzeichnet, daß**

$$\Psi(\gamma) = \Psi_{HA}(\gamma) = \sqrt{\gamma^2 + \left(\frac{2}{\pi - 2}\right)^2} \quad .$$

7. Verfahren nach Anspruch 1, **dadurch gekennzeichnet, daß** die Anzahl $N$ der Abtastwerte des zu verarbeitenden modulierten Kommunikationssignals $r_n$ gleich oder kleiner als 500 ist, vorzugsweise gleich oder kleiner als 100.

8. Computerprogramm zum Schätzen des Signal-Rausch-Abstandes $\gamma$ eines modulierten Kommunikationssignals $r_n$, wobei das Programm die Schritte der Verfahren implementiert, die in Anspruch 1 definiert sind.

9. Empfängersystem, umfassend Einrichtungen zum Durchführen der Schritte des Verfahrens, das in Anspruch 1 definiert ist.

10. Vorrichtung, insbesondere eine Basisstation oder eine Mobilstation, umfassend ein Computerprogramm nach Anspruch 8 und/oder ein Empfängersystem nach Anspruch 9.

**Revendications**

**1.** Procédé d'évaluation du rapport signal sur bruit $\gamma$ d'un signal de communication modulé $r_n$ comprenant une composante symbole de données $s_n$ et une composante bruit $n_n$, dans lequel la valeur du SNR intermédiaire $\gamma_{RDA}$ du signal de communication modulé est déterminée, et dans lequel une valeur du SNR estimé $\gamma_{RDA-ER}$ est déterminée par une conversion non linéaire contrôlée de la valeur du SNR intermédiaire $\gamma_{RDA}$,
**caractérisé en ce que**,
la valeur du SNR intermédiaire $\gamma_{RDA}$ est dérivée d'une estimation du maximum de vraisemblance de données assistées, les données assistantes n'étant pas connues à l'avance mais étant reconstruites à partir d'échantillons du signal de communication modulé $r_n$.

**2.** Procédé selon la revendication 1, **caractérisé en ce que** la conversion non linéaire contrôlée s'effectue au moyen d'une fonction de correction $\Psi^{-1}$, avec $\gamma_{RDA-ER} = \Psi^{-1}(\gamma_{RDA})$, dans laquelle la fonction de correction $\Psi^{-1}$ est la fonction inverse d'une fonction d'écart estimé $\Psi$, cette fonction d'écart estimé $\Psi$ se rapprochant d'une fonction d'écart vrai $\Psi_{true}$ corrélant l'écart de $\gamma_{RDA}$ à partir de $\gamma$, c.-à-d. $\gamma_{RDA} = \Psi_{true}(\gamma)$ et $\Psi(\gamma) \approx \Psi_{true}(\gamma)$.

**3.** Procédé selon la revendication 2, **caractérisé en ce que** $\Psi$ est choisi tel que $\Psi(\gamma)=\Psi_{true}(\gamma)$ pour un grand nombre de $N$, c.-à-d. $N \to \infty$, avec $N$ étant le nombre d'échantillons du signal de communication modulé $r_n$ traités.

**4.** Procédé selon la revendication 2, **caractérisé en ce que**

$$\Psi(\gamma) = \cfrac{1}{\cfrac{\gamma+1}{\left(\sqrt{\gamma}\,\mathrm{erf}\left(\sqrt{\dfrac{\gamma}{2}}\right)+\sqrt{\dfrac{2}{\pi}}e^{-\frac{\gamma}{2}}\right)^2}-1}$$

**5.** Procédé selon la revendication 2, **caractérisé en ce que** $\Psi^{-1}$ est appliquée au moyen d'une table d'approximation.

**6.** Procédé selon la revendication 2, **caractérisé en ce que**

$$\Psi(\gamma) = \Psi_{HA}(\gamma) = \sqrt{\gamma^2 + \left(\dfrac{2}{\pi-2}\right)^2}\,.$$

**7.** Procédé selon la revendication 1, **caractérisé en ce que** le nombre $N$ d'échantillons du signal de communication modulé $r_n$ traités est égal ou inférieur à 500, de préférence égal ou inférieur à 100.

**8.** Logiciel d'estimation du rapport signal sur bruit $\gamma$ d'un signal de communication modulé $r_n$, ledit logiciel mettant en application les étapes des procédés définis dans la revendication 1.

**9.** Système récepteur comprenant les moyens servant à exécuter les étapes du procédé défini dans la revendication 1.

**10.** Appareil, en particulier une station de base ou une station mobile, comprenant un logiciel selon la revendication 8 et/ou un système récepteur selon la revendication 9.

Fig. 1

$$r_n = \alpha\, s_n + n_n$$

Fig. 2

BPSK1: 100 Samples per SNR Estimation

Fig. 3a

EP 1 677 445 B1

Fig. 3b

BPSK1: 1000 Samples per SNR Estimation

RDA
RDA-ER
RDA-ERHA

NMSE

SNR in dB

BPSK1: 100 Samples per SNR Estimation

Fig. 4a

BPSK1: 1000 Samples per SNR Estimation

Fig. 4b